# EUROPEAN PATENT APPLICATION

(11) **EP 2 377 835 A1**
(43) Date of publication of application: **19.10.2011**
(21) Application number: 10160128.4
(22) Date of filing: 16.04.2010
(51) Int. Cl.: C04B 35/111, H05K 3/46

(54) **Green sheet**

(71) Applicant: Nippon Electric Glass Co., Ltd., Otsu-shi Shiga 520-8639 (JP)
(72) Inventor: Hosoda, Yohei, Shiga 5208639 (JP)
(74) Representative: Tetzner, Michael

(57) **Abstract**

A green sheet comprises a glass powder, a ceramic powder, and a binder, wherein the glass powder is substantially free of PbO, and the binder has an acid value of 0.1 to 4.5.

## Description

### Technical Field

The present invention relates to a green sheet to be used for a multilayer interconnection circuit board, or the like, and more specifically, to a green sheet suitable for a multilayer interconnection circuit board in which a metal having a low melting point such as Ag or Cu is used as a wiring material, or the like.

### Background Art

A green sheet, in which an alumina-based ceramic powder is used, has conventionally been used for mounting a semiconductor device such as an LSI. However, because the alumina-based ceramic powder has a higher sintering temperature, it is required to use a metal having a higher melting point, such as W or Mo, as a wiring material that can be sintered simultaneously, and hence, there has been such a problem that its conductive resistance is increased to 10 to 20 mΩ/□ (mΩ/mm²). In order to solve the problem, a multilayer interconnection circuit board, in which a metal having a low melting point such as Ag or Cu is used for wiring, has been put into a practical use. Subjecting the wiring material to simultaneous sintering requires the use of a green sheet containing a glass powder having a low melting point.

The above-mentioned multilayer interconnection circuit board is produced by forming a via hole on a green sheet as the need arises, and then printing a wiring pattern with a metallization paste, performing lamination, eliminating a binder, and sintering the resultant at 1,000°C or less.

In general, a green sheet is produced in such a manner that a slurry containing a glass powder, a ceramic powder, a binder, a solvent, and a plasticizer is uniformly placed on a PET film by a doctor blade method, and the slurry is continuously dried.

### Citation List

Patent document 1: JP-A-2-35790

### Summary of Invention

### Technical Problem

Conventionally, for a green sheet, a PbO-containing glass powder having a low melting point has been used and polyvinyl butyral has been used as a binder. However, because the polyvinyl butyral is inferior in thermal degradability, the use of an acrylic resin excellent in thermal degradability has been increasing in recent years. For example, Patent document 1 proposes a binder made of a methyl methacrylate polymer.

In recent years, from the environmental viewpoint, studies have been made to replace a lead-free glass powder to a PbO-containing glass powder. However, when a green sheet is produced by using a lead-free glass powder and a conventional binder, dispersibility of slurry lowers, and poor appearance such as stripes or unevenness is liable to occur on the green sheet, with the result that the strength of the circuit board is liable to be deteriorated after the sintering of the green sheet. Further, when a green sheet is produced by using a lead-free glass powder and a conventional binder, a viscosity change ratio of the slurry (hereinafter referred to as "viscosity increase ratio") increases, causing a difficulty in forming the green sheet uniformly. In other words, fluctuations of thicknesses of the green sheets are liable to occur, with the result that the strength of the circuit board is liable to be deteriorated.

Thus, a technical object of the present invention is to design, in the case of producing a green sheet using a lead-free glass powder, a binder, which does not easily cause poor appearance on the green sheet, and does not easily cause an elevation of the viscosity increase ratio, thereby enhancing the strength of the circuit board after sintering so as to produce a highly reliable multilayer interconnection circuit board.

### Solution to Problem

The inventors of the present invention have intensively studied and found that even if a lead-free glass powder is used, through limitation of the acid value of a binder to fall within a predetermined range poor appearance hardly occurs, an elevation of the viscosity increase ratio hardly occurs, and the strength of the circuit board after sintering can be enhanced. Thus, the inventors of the present invention propose the finding as the present invention. That is, a green sheet of the present invention includes a glass powder, a ceramic powder, and a binder, and is characterized in that the glass powder is substantially free of PbO and the binder has an acid value of 0.1 to 4.5. Here, the phrase "a glass powder is substantially free of PbO" refers to a case where a content of PbO in the glass powder is 1,000 ppm or less. Further, the term "acid value" refers to an mg number of KOH necessary for neutralizing 1 g of a binder. It should be noted that the "glass powder" of the present invention includes a crystalline glass powder that causes precipitation of a crystal in glass after its thermal treatment or the like.

In the green sheet of the present invention, the glass powder is substantially free of PbO. This can meet environmental requirements in recent years. It should be noted that the use of a glass powder allows a green sheet to be sintered at low temperatures, and hence, a metal having a low melting point can be used for a wiring material.

The inventors of the present invention have found that even if a similar binder is used, the behavior of a slurry containing a PbO-containing glass powder is remarkably different from that of a slurry containing a lead-free glass powder, thereby generating a remarkable difference in the characteristics of the resulting green sheets. The reason why the above-mentioned phenomenon occurs is not clarified in detail, and a mechanism of the phenomenon is not clarified either. Thus, intensive investigations on both are underway. The inventors of the present invention presume that the adsorption amount of the binder to the glass powder remarkably varies depending on the presence or absence of PbO in the glass powder, reflecting the different characteristics of the green sheets. The inventors presume that if the lead-free glass powder is used, the acid value of the binder must be strictly controlled, otherwise fluidity of the slurry does not fall within a proper range, thereby influencing the characteristics of the green sheet.

In the green sheet of the present invention, the acid value of the binder is controlled to 4.5 or less. This results in higher dispersibility of a slurry, and poor appearance such as stripes or unevenness on the green sheet hardly occurs, with the result that the strength of the circuit board can be enhanced. Further, this results in the viscosity increase ratio hardly increases, thereby being easy to form a uniform green sheet. As a result, the strength of the circuit board can be enhanced.

In the green sheet of the present invention, the acid value of the binder is controlled to 0.1 or more. This results in a reduction in the drying speed at the time of continuous drying of a slurry, and poor appearance such as stripes or unevenness on the green sheet hardly occurs. As a result, the strength of the circuit board can be enhanced. Further, this results in an increase in sheet density, thereby lowering a shrinkage ratio of the green sheet. As result, the warpage of the circuit board can easily be prevented if the green sheet is sintered. Still further, this results in that the viscosity increase ratio hardly increases, thereby being easy for forming uniform green sheet. As a result, the strength of the circuit board can be enhanced.

The acid value of the binder can be controlled by subjecting carboxylic acids having a double bond between carbons, such as acrylic acid, methacrylic acid, fumaric acid, and maleic acid, to copolymerization. Specifically, along with the increase of the ratio of copolymerization of carboxylic acids having a double bond between carbons, a binder with a higher acid value can be provided.

The green sheet of the present invention contains a ceramic powder. This enables the enhancement of the strength of the circuit board. It should be noted that like the glass powder, the ceramic powder is preferably substantially free of PbO.

In the green sheet of the present invention, the binder is preferably an acrylic resin. This enables decomposition and volatilization of the binder at low temperatures, and carbons and the like hardly remains in a sinteredbody. As a result, the viscosity characteristics of the slurry can be easily adjusted.

In a green sheet of the present invention, the binder preferably has a weight-average molecular weight Mw of 80,000 or more and a number-average molecular weight Mn of 10, 000 or more. This enhances the strength of the circuit board and prevents the wettability of the glass powder from easily declining even if the binder has a low acid value. Here, "a weight-average molecular weight Mw of a binder" and "a number-average molecular weight Mn of a binder" can be determined by a GPC method, or the like.

In a green sheet of the present invention, the glass powder preferably contains, as a glass composition, 35 to 65% of SiO₂, 8 to 25% of Al₂O₃, 15 to 35% of CaO, and 4 to 12% of B₂O₃. This enables the sintering of the green sheet at low temperatures, and allows anorthite to precipitate in the glass after the sintering of the green sheet. As a result, the strength of the circuit board can be enhanced.

In a green sheet of the present invention, a mixing ratio of the glass powder to the ceramic powder is preferably 40:60 to 65:35 in terms of a mass ratio. This can enhance the strength of the circuit board while the density of the sintered body is maintained.

In a green sheet of the present invention, the ceramic powder is preferably an alumina powder. This can increase the strength of the circuit board while the density of the sintered body is maintained.

A sintered body of the present invention can be formed by sintering the green sheet.

In a sintered body of the present invention, anorthite is preferably precipitated.

A sintered body of the present invention is preferably used for a multilayer interconnection circuit board.

### Description of Embodiments

In the green sheet of the present invention, the acid value of the binder is 0.1 to 4.5, preferably 0.5 to 3.8, more preferably 0.8 to 3, or still more preferably 1.2 to 2. When the acid value of the binder is higher than 4.5, an adsorption amount of the glass powder to the binder rises, lowering dispersibility of a slurry, and poor appearance such as stripes or unevenness hardly occur. As a result, the strength of the circuit board is liable to be deteriorated. Further, when the acid value of the binder is higher than 4.5, the viscosity increase ratio easily increases, causing a difficulty in forming the green sheet uniformly. As a result, the strength of the circuit board is liable to be deteriorated. On the other hand, when the acid value of the binder is lower than 0.1, the drying speed rises at the time of continuous drying of the slurry, to thereby lead to a more chance of occurrence of poor appearance such as stripes or unevenness, with the result that the strength of the circuit board is liable to be deteriorated. Further, when the acid value of the binder is lower than 0.1, the sheet density easily declines, causing an increase in the shrinkage ratio of the green sheet. As a result, the warpage of the circuit board is liable to occur when the green sheet is sintered. Still further, when the acid value of the binder is lower than 0.1, the viscosity increase ratio easily increases, causing a difficulty in forming the green sheet uniformly. As a result, the strength of the circuit board is liable to be deteriorated.

In the green sheet of the present invention, the weight-average molecular weight Mw of the binder is preferably 80,000 or more or particularly preferably 100,000 or more, and the number-average molecular weight Mn of the binder is preferably 10,000 or more or particularly preferably 13,000 or more. When the weight-average molecular weight Mw of the binder is smaller that 80, 000, the binding of the binders to each other becomes insufficient. As a result, the strength of the green sheet is liable to be deteriorated. In addition to that, when the acid value of the binder is low, the wettability with the glass powder is liable to be deteriorated. Likewise, when the number-average molecular weight Mn of the binder is smaller than 10,000, the binding of the binders to each other becomes insufficient. As a result, the strength of the green sheet is liable to be deteriorated. In addition to that, when the acid value of the binder is low, the wettability with the glass powder is liable to be deteriorated.

In the green sheet of the present invention, the glass-transition temperature of the binder is preferably 80°C or less, 50°C or less, or particularly preferably 35°C or less. When the glass-transition temperature of the binder is higher than 80°C, the plasticity of the green sheet deteriorates. As a result, cracks liable to occur in the green sheet at the time of formation of a via hole in the green sheet.

Various binders may be used in the green sheet of the present invention as long as the binder has satisfactory thermal decomposition property, and of those, an acrylic resin is preferred. An acrylic resin has satisfactory viscosity property and thermal decomposition property, and the binder can be removed from the resin at low temperature. As the acrylic resin, there may be used: an acrylic acid ester such as methyl acrylate and ethyl acrylate; a methacrylic acid ester such as methyl methacrylate, ethyl methacrylate, butyl methacrylate, 2-ethylhexyl methacrylate, and stearyl methacrylate; and a resin obtained by polymerizing one kind or two or more kinds of monomers having a functional group such as 2-hydroxyethyl methacrylate and dimethylamino methacrylate.

When a green sheet is produced, a plasticizer is usually added in a slurry. The plasticizer serves as a component that controls the drying speed and as a component that gives flexibility to the green sheet. There can be used butyl benzyl phthalate, dioctyl phthalate, diisooctyl phthalate, dicapryl phthalate, dibutyl phthalate, or the like as the plasticizer. They can be used alone or in mixture.

In general, a solvent is added as a component for making the raw material into a slurry when producing the green sheet. As the solvent, there may be used toluene, terpineol, methyl ethyl ketone, diethylene glycol monobutyl ether acetate, 2,2,4-trimethyl-1,3-pentadiol monoisobutylate, methyl isobutyl ketone, or the like. Those solvents may be used alone or in a mixture.

When a green sheet is produced by a doctor blade method, the slurry viscosity at 25°C is preferably 1 to 50 Pa·s, more preferably 2 to 30 Pa·s, or particularly preferably 3 to 20 Pa·s. If the slurry viscosity is lower than 1 Pa·s, a crater is liable to occur at the time of the formation of the green sheet, and fluctuation in thickness of the green sheet easily occurs. On the other hand, if the slurry viscosity is higher than 50 Pa·s, the fluidity of the slurry is lowered. As a result, poor appearance such as unevenness or stripes is liable to occur on the green sheet. It should be noted that appropriate adjustment of the contents of a binder, plasticizer, and solvent allows the adjustment of the slurry viscosity.

The glass powder according to the present invention preferably has property of precipitating a crystal after being sintered. This enables an enhancement of the mechanical strength of the sintered body.

The glass powder according to the present invention has a glass composition preferably containing SiO₂, Al₂O₃, CaO, and B₂O₃, and the content range of SiO₂ Al₂O₃, CaO, and B₂O₃ is preferably 35 to 65% of SiO₂, 8 to 25% of Al₂O₃, 15 to 35% of CaO, and 4 to 12% of B₂O₃, and the glass powder particularly preferably contains 38.3 to 59.4% of SiO₂, 9.9 to 19.0% of Al₂O₃, 18.7 to 33.7% of CaO, and 5 to 9% of B₂O₃. The glass powder may be made of glass containing only the above-mentioned four components, or may be glass containing arbitrary components such as MgO, Na₂O, TiO₂, and SrO in total at 10 mass% or less or preferably at 3 mass% or less. The glass powder having the above-mentioned glass composition has the property of easily precipitating anorthite on glass when the glass powder is sintered with a ceramic powder containing Al₂O₃.

Further, the glass powder according to the present invention contains, as a glass composition, preferably 0.1 to 1 mass% of Fe₂O₃ or particularly preferably 0.15 to 0.5 mass%. If the content of Fe₂O₃ is less than 0.1 mass%, the sintered body is hardly colored, and hence, when a silver conductor is used, recognition with an optical reader is easily performed. As a result, automatic mounting of for the circuit board can easily be performed. On the other hand, if the content of Fe₂O₃ is more than 1 mass%, the dielectric loss easily rises.

In the glass powder according to the present invention, the liquidus temperature is preferably 1,200° or less. If the liquidus temperature of glass is high, a crystal easily precipitates in glass when molten glass is cooled. If a glass powder in which a crystal is precipitated is used for a green sheet, when the green sheet is sintered, the crystal serves as a nucleus to cause crystallization of glass at lower temperature than the case where glass is free of a crystal. Crystallization of glass at low temperatures inhibits the liquidity of glass, making the dense sintering of a green sheet difficult, with the result that a highly reliable circuit board is not easily provided. Further, when the liquidus temperature of glass is high, it is necessary to increase the melting temperature of glass for the stable production of a glass powder, which causes an increase in energy cost and a reduction in the lifetime of a melting furnace, with the result that the production cost of the glass powder soars.

In the green sheet of the present invention, one kind or two or more kinds of oxide-based ceramic powders such as alumina, mullite, forsterite, cristobalite, quartz, zirconia, zircon, aluminate spinel, and cordierite, and nonoxide-based ceramic powders such as aluminum nitride, boron nitride, and silicon nitride may be used as the ceramic powder. In particular, alumina is favorable in terms of cost and strength.

In the green sheet of the present invention, the mixing ratio of a glass powder to a ceramic powder is preferably 40:60 to 65:35 in terms of a mass ratio. When the content of the ceramic powder is too large, providing a dense sintered body becomes difficult. On the other hand, when the content of the ceramic powder is too small, the strength of the circuit board is liable to be deteriorated.

Next, a method of producing a green sheet and a method of producing a multilayer interconnection circuit board are described.

First, a glass powder, a ceramic powder, a binder, a plasticizer, a solvent, and the like each having a predetermined amount to prepare a slurry. Next, the resultant slurry is formed into a green sheet by a doctor blade method, or the like. Subsequently, the green sheet is dried and cut into pieces having a predetermined size, and then a via hole is formed in the resultant green sheet by mechanical processing or the like. Besides, a wiring pattern is printed with a metallization paste containing a wiring material having a low melting point (specifically, silver conductor or copper conductor) on the surface of the green sheet and on the via hole. Finally, a plurality of green sheets are laminated, the resultant laminate undergoes thermal compression bonding to have an integrated body, and the body is sintered, to thereby produce a multilayer interconnection circuit board. To perform simultaneous sintering of the green sheet and the metallization paste, the sintering temperature is desirably 800 to 1,000°C or particularly desirably 800 to 950°C. Further, it is desired that the sintering be performed in air when a silver conductor is used, and that the sintering be performed in nitrogen when a copper conductor is used. It should be noted that the green sheet of the present invention can use not only in application to a multilayer interconnection circuit board, but also in application to a semiconductor package, laminated chip parts, or the like.

The sintered body of the present invention is characterized by being formed by sintering the above-mentioned green sheet. The technical characteristics (suitable aspect, suitable numerical range, and the like) of the sintered body of the present invention has already been described in the description of the green sheet of the present invention, and hence, the description thereof is omitted for convenience sake.

In the sintered body of the present invention, preferably crystal is precipitate, or particularly preferably anorthite is precipitate. This enables an enhancement of the mechanical strength of the sintered body.

### Examples

Hereinafter, the present invention is described by way of examples.

First, a glass raw material was prepared so that the glass material had the glass composition shown in Table 1. The glass material was loaded into a platinum crucible and melted at 1, 400°C to 1,550°C for 3 hours, and the resultant was formed into a film shape using a water-cooling roller. Next, the glass film was ground into a coarse product with a ball mill, and then water was added to the resultant product, followed by wet grinding to yield a glass powder (having an average particle diameter of 3 µm). In addition, an alumina powder (having an average particle diameter of 2 µm) was added to the glass powder at the ratio shown in the table to prepare a mixture. The resultant serves as a powdered sample.

**Table 1**

| | | Powdered sample | | |
|---|---|---|---|---|
| | | A | B | C |
| Glass powder Glass composition (mass%) | SiO₂ | 55.6 | 41.0 | 59.1 |
| | Al₂O₃ | 14.8 | 18.0 | - |
| | MgO | - | - | 3.2 |
| | CaO | 23.2 | 32.2 | 7.9 |
| | B₂O₃ | 6.4 | 8.8 | 6.0 |
| | PbO | - | - | 18.0 |
| | Na₂O | - | - | 3.4 |
| | K₂O | - | - | 2.4 |
| Glass powder/ceramic powder (mass ratio) | | Alumina 50/50 | Alumina 50/50 | Alumina 50/50 |

Table 2 shows examples (Sample Nos. 1 to 4) and comparative examples (Sample Nos. 5 to 7) of the present invention. It should be noted that Sample No. 7 shows a conventional example.

**Table 2**

| | | Example | | | | Comparative Example | | |
|---|---|---|---|---|---|---|---|---|
| | | No. 1 | No. 2 | No. 3 | No. 4 | No. 5 | No. 6 | No. 7 (Conventional Example) |
| Powdered sample | | A | A | B | A | A | A | C |
| Binder (acrylic resin) | Acid value | 0.8 | 1.7 | 1.7 | 3.8 | 0 | 4.8 | 4.8 |
| | Mw | 140,000 | 145,000 | 145,000 | 130,000 | 140,000 | 135,000 | 135,000 |
| | Mw/Mn | 8.0 | 8.1 | 8.1 | 7.7 | 8.0 | 7.9 | 7.9 |
| | Tg (°C) | 29 | 29 | 29 | 29 | 29 | 29 | 29 |
| Appearance | | A | A | A | B | C | C | A |
| Viscosity increase ratio (%) | | 1.6 | 1.7 | 1.7 | 1.9 | 1.5 | 2.1 | 1.6 |
| Shrinkage ratio (%) | | 18.5 | 18.5 | 18.5 | 19.0 | 18.0 | 20.0 | 18.0 |

A powdered sample shown in the table, a binder (acrylic resin) having physical properties shown in the table, a solvent (methyl ethyl ketone), and a plasticizer (butyl benzyl phthalate) were mixed to prepare a predetermined slurry. Next, the resultant slurry was formed into a green sheet having a thickness of 0.2 mm by a doctor blade method, or the like. The resultant green sheet was evaluated for appearance, viscosity increase ratio, and shrinkage ratio.

The appearance evaluation was carried out through visual observation. The case where stripes and unevenness were not generated on the surface of the green sheet was defined as "A", the case where stripes and unevenness were slightly generated was defined as "B", and the case where stripes and unevenness were generated was defined as "C". The evaluation was carried out based on the above definitions.

Slurry viscosity at the initial stage and that at a stage after keeping the slurry at a still standing state for 24 hours were determined by a viscometer, and a percentage of an increase in the slurry viscosity was calculated to provide the viscosity increase ratio.

The evaluation of the shrinkage ratio was performed by sintering a green sheet at 900°C for 3 hours, thereby producing a sintered body of a square, 50 mm on a side. Specifically, each of the shrinkage ratio in the X direction and the shrinkage ratio in the Y direction before and after the sintering was measured, and values were calculated based on the expression (X+Y)/2. The resultant values were used for the evaluation.

As is evident from Table 2, sample Nos. 1 to 4 received favorable evaluations on appearance, viscosity increase ratio, and shrinkage ratio because each of the powdered samples was substantially free of PbO and the acid value of the binders was limited to fall within a predetermined range. On the other hand, sample No. 5 received a poor evaluation on appearance because the acid value of the binder was 0. Sample No. 6 received poor evaluations on appearance, viscosity increase ratio, and shrinkage ratio because the acid value of the binder was large. Sample No. 7 received favorable evaluations on appearance, viscosity increase ratio, and shrinkage ratio, but cannot meet environmental requirements in recent years because PbO is contained in the glass composition of the glass powder.

### Industrial Applicability

The green sheet of the present invention can be suitably used for a multilayer interconnection circuit board such as a laminated condenser, a laminated inductor, or a laminated module board.

## Claims

1. A green sheet comprising a glass powder, a ceramic powder, and a binder, **characterized in that** the glass powder is substantially free of PbO, and the binder has an acid value of 0.1 to 4.5.

2. A green sheet according to claim 1, **characterized in that** the binder comprises an acrylic resin.

3. A green sheet according to claim 1 or 2, **characterized in that** the binder has a weight-average molecular weight Mw of 80, 000 or more and a number-average molecular weight Mn of 10, 000 or more.

4. A green sheet according to any one of claims 1 to 3, **characterized in that** the glass powder contains, as a glass composition, 35 to 65% of SiO₂, 8 to 25% of Al₂O₃, 15 to 35% of CaO, and 4 to 12% of B₂O₃.

5. A green sheet according to any one of claims 1 to 4, **characterized in that** a mixing ratio of the glass powder to the ceramic powder is 40:60 to 65:35 in terms of a mass ratio.

6. A green sheet according to any one of claims 1 to 5, **characterized in that** the ceramic powder comprises an alumina powder.

7. A sintered body, **characterized by** being formed by sintering the green sheet according to any one of claims 1 to 6.

8. A sintered body according to claim 7, **characterized in that** anorthite is precipitated.

9. A sintered body according to claim 7 or 8, **characterized by** being used for a interconnection circuit board.
